# EUROPÄISCHE PATENTANMELDUNG

(11) **EP 2 019 454 A2**
(43) Veröffentlichungstag der Anmeldung: **28.01.2009**
(21) Anmeldenummer: 08104599.9
(22) Anmeldetag: 02.07.2008
(51) Int. Cl.: H01R 12/32

(54) **Stiftförmiges Kontaktelement und Steckverbindung**

(30) Priorität: 27.07.2007 DE 102007035325
(71) Anmelder: ROBERT BOSCH GMBH, 70442 Stuttgart (DE)
(72) Erfinder: Moser, Manfred, 72768 Reutlingen (DE); Gueckel, Richard, 76829 Landau/Pfalz (DE); Zywietz, Martin, 71642 Ludwigsburg (DE)

(57) **Zusammenfassung**

Die vorliegende Erfindung stellt ein Kontaktelement (1) bereit zur kontaktgebenden Befestigung in einer Pinaufnahme einer Leiterplatte (10), wobei das Kontaktelement (1) eine im Wesentlichen nadelöhrförmigen Einpresszone (2) aufweist, mit:
zwei fcdcrclastisch aufeinander zu bewegbaren Kontaktschenkeln (5), deren Enden auf beiden Seiten miteinander verbunden sind, und
einem als Federelement dienenden Steg (6), welcher zwischen den Kontaktschenkeln (5) angeordnet ist, wobei der Steg (6) derart verformt ist, dass er eine vordefinierte Ausknickrichtung aufweist.

## Beschreibung

### STAND DER TECHNIK

Die vorliegende Erfindung betrifft stiftförmiges Kontaktelement und eine dasselbe aufweisende Steckverbindung.

Stiftförmige Kontaktelemente, welche auch als "Pins" bekannt sind, dienen zum Herstellen einer elektrisch leitenden Verbindung einer elektrischen oder elektronischen Vorrichtung mit einer Leiterbahn einer elektrischen Leiterplatte. Typischerweise ist die Leiterplatte dabei mit metallisierten Lochungen bzw. Durchgangslöchern versehen, in welche die stiftförmigen Kontaktelemente eingepresst werden.

Bekannt sind Kontaktstifte, die an ihrem Ende mit einer nadelöhrförmigen Einpresszone versehen sind. In dieser Einpresszone sind zwei Schenkel vorgesehen, welche beim Einpressen in die Leiterplatte elastisch aufeinander zu bewegt werden und somit durch Federkraft gegen die Metallisierung der Pinaufnahme gepresst werden. Der Kontaktstift wird somit sicher in der Pinaufnahme gehalten. Allerdings besteht bei dieser Anordnung der Nachteil, dass die durch die Federkraft bedingten Haltekräfte nicht über die Lebensdauer der Verbindung konstant sind, sondern mit der Zeit abnehmen. Dies ist insbesondere dann der Fall, wenn die Verbindungen großen Temperaturschwankungen ausgesetzt ist, da das wiederholte Ausdehnen und Zusammenziehen der das Nadelöhr definierenden Schenkel zu einem Abnehmen der Federkraft führt.

Die europäische Patentanmeldung EP 0 209 936A1 offenbart einen Kontaktstift mit einem im Querschnitt H-förmigen Kontaktbereich, in dem vier Rippen von einem mittleren Querstück abstehen. Beim Einpressen in die Pinaufnahme werden diese vier Rippen gleichförmig gebogen und drücken somit durch ihre Rückstellkraft gegen die Metallisierung der Pinaufnahme. Dabei ist es wichtig, dass die einzelnen Rippen eine identische Dicke und Steifheit aufweisen, da eine unterschiedliche Steifheit zu einer Rotation oder exzentrischen Anordnung des Kontaktstifts führen kann. Die EP 0 209 936A1 schlägt daher vor, dass das Querstück im Querschnitt eine V-Form definiert. Dies soll sicherstellen, dass eine absolut symmetrische Einpresszone erzielt wird, so dass die Rippen auf beiden Seiten genau dieselbe Dicke und Steifheit aufweisen.

Bei den bekannten Anordnungen ist kann es jedoch zu dem im Folgenden geschilderten Problem kommen.

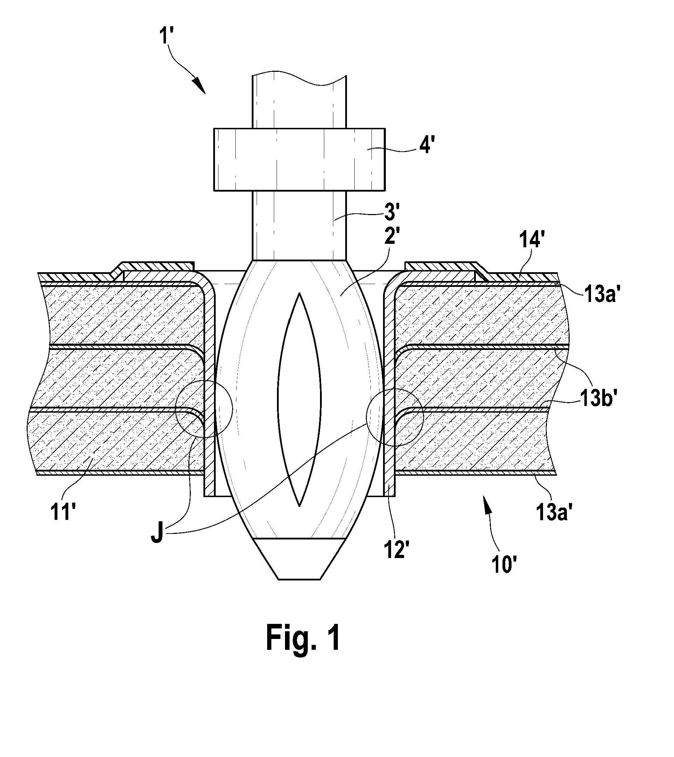

Fig. 1 zeigt schematisch eine herkömmliche Steckverbindung, in welcher der Kontaktstift 1' mit einer nadelöhrförmigen Einpresszone 2' versehen ist. An die Einpresszone 2' schließt sich ein zylindrischer Kontaktdraht 3' an. Die nadelöhrförmige Einpresszone 2' ist mit einer (nicht dargestellten) Feder versehen, welche als Steg zwischen den beiden Schenkeln der Einpresszone 2' ausgebildet ist.

Die Leiterplatte 10' umfasst eine plattenförmige Glasfasermatrix 11', in welcher ein Durchgangsloch ausgebildet ist. In dieses Durchgangsloch ist eine hohlzylindrische Aufnahmehülse 12' aus Kupfer eingesetzt, welche das Durchgangsloch von innen auskleidet. Die Aufnahmehülse 12' ist mit metallischen Leiterbahnen 13a' und 13b' in Kontakt, welche ebenfalls aus Kupfer bestehen. Die Leiterbahnen 13a' und 13b' umfassen Außenbahnen 13a', welche an der Oberfläche der Leiterplatte 10' vorgesehen sind, sowie Innenbahnen 13b', welche parallel zur Oberfläche der Leiterplatte 10' im Innern der Leiterplatte 10' verlaufen. Die in der Leiterplatte 10' vorgesehene Aufnahmehülse 12' bildet eine Pinaufnahme für den Kontaktstift 1'. An der Oberfläche der Leiterplatte 10' ist eine die obere Leiterbahn bedeckende Lötstoppmaske 14' vorgesehen.

Durch das Einpressen des Kontaktstifts 1' in die Pinaufnahme wird der elektrische Kontakt zwischen dem Kontaktstift 1' und den Leiterbahnen 13a' und 13b' hergestellt. Wird der Kontaktstift 1' zu diesem Zwecke in die Pinaufnahme gedrückt, dann werden die beiden Schenkel der Einpresszone 2' zusammengedrückt. Dabei knickt die Feder früher oder später seitlich weg und wird somit gespannt. Das Einpressen in die Leiterplatte 10' wird durch eine Einpressschulter 4' begrenzt.

Hierbei variiert jedoch die Kraft, mit welcher die beiden Schenkel zusammengedrückt werden müssen, um die Feder auszuknicken, stark und kann beispielsweise von der Verarbeitungsgenauigkeit der Einpresszone abhängen. Dies bedeutet jedoch, dass auch die zum Einpressen benötigten Einpresskräfte stark schwanken. Wird nun ein Kontaktstift mit einer Kraft F in die Pinaufnahme gepresst, dessen Feder erst beim Aufbringen einer großen Kraft ausknickt, dann ist die Einpresszone schon weit in die Aufnahmehülse 12' hineingeschoben, bevor sich die Schenkel zusammendrücken lassen. Da die Einpresszone 2' jedoch, um einen ausreichenden Kontakt zu gewährleisten, an ihrer breitesten Stelle breiter ist als die Aufnahmehülse 12', wird die Aufnahmehülse 12' verformt und von dem Kontaktstift 1' ein Stück weit nach unten gezogen. Dadurch werden insbesondere die inneren Leiterbahnen 13b' deformiert. Diese Deformation wird auch Jet-Effekt genannt (vgl. Bereich J in Fig. 1). Im Extremfall kann dabei die Verbindung zwischen den Leiterbahnen und der Aufnahmehülse 12' abreißen und somit der Kontakt zu den Leiterbahnen nicht gewährleistet werden.

### VORTEILE DER ERFINDUNG

Demgemäß vorgesehen ist ein stiftförmiges Kontaktelement zur kontaktgebenden Befestigung in einer Pinaufnahme einer Leiterplatte, wobei das Kontaktelement eine im Wesentlichen nadelöhrförmige Einpresszone aufweist, mit:
zwei federelastisch aufeinander zu bewegbaren Kontaktschenkeln, deren Enden auf beiden Seiten miteinander verbunden sind, und
einem als Federelement dienenden Steg, welcher zwischen den Kontaktschenkeln angeordnet ist, wobei der Steg derart verformt ist, dass er eine vordefinierte Ausknickrichtung aufweist.

Dadurch, dass das zwischen den Kontaktschenkeln angeordnete Federelement mit einer vordefinierten Ausknickrichtung versehen ist, ergeben sich mehrere Vorteile: Zum einen wird die zum Ausknicken benötigte Einpresskraft reduziert. Zum anderen wird die Schwankungsbreite der benötigten Einpresskraft reduziert und somit diese Einpresskraft genauer bestimmbar bzw. vorhersagbar. Dies macht das erfindungsgemäße Kontaktelement für automatisierte Einpressvorgänge mit Hilfe eines Placement-Tools besonders geeignet.

Es ist vorteilhaft, wenn die zwei Kontaktschenkeln jeweils einen ersten, einen zweiten und einen dritten Abschnitt aufweisen, wobei der zweite Abschnitt zwischen dem ersten und dem dritten Abschnitt angeordnet ist und die ersten Abschnitte und die dritten Abschnitte der Kontaktschenkel an ihren dem zweiten Abschnitt abgewandten Enden jeweils miteinander verbunden sind, und der Steg zwischen den zweiten Abschnitten der Kontaktschenkel angeordnet ist, so dass der Steg zusammen mit den ersten und den dritten Abschnitten jeweils eine Öffnung definiert. Dies ermöglicht es, die zum Ausknicken der Feder benötigten Kräfte genauer zu definieren.

Eine Vordefinierung der Ausknickrichtung kann dabei dadurch erreicht werden, dass der Steg einen mittleren Bereich aufweist, welcher gegenüber den den Kontaktschenkeln zugewandten Enden des Stegs zu einer Seite hin gewölbt ist, so dass der Steg beim Einpressen des Kontaktelements in die Pinaufnahme zu dieser Seite hin ausknickt.

Dabei ist es besonders vorteilhaft, wenn der durch die Wölbung vorgegebene Versatz des mittleren Stegbereiches so groß ist, dass sowohl eine Unterseite als auch eine Oberseite des Stegs im mittleren Stegbereich auf der selben Seite einer die beiden Kontaktschenkel verbindenden Linie durch die Mitte des Stegs liegen. Somit wird gewährleistet, dass ein Ausknicken des Stegs schon bei relativ geringer Kraftbeaufschlagung einsetzt.

In einer vorteilhaften Ausgestaltung sind die ersten Abschnitte der Kontaktschenkel am freien Ende des Kontaktelements im Wesentlichen parallel zueinander angeordnet und sind vom freien Ende zu den zweiten Abschnitten hin nach außen gespreizt. Die ersten Abschnitte bilden somit im Wesentlichen eine abgerundete Y-Form, was das Einsetzen des Kontaktelements in eine PinAufnahme erleichtert.

In einer weiteren vorteilhaften Ausgestaltung sind die zweiten Abschnitte der Kontaktschenkel im Wesentlichen gerade ausgebildet sind. Somit wird die Kontaktfläche zwischen dem Kontaktelement und der Pinaufnahme im eingesetzten Zustand vergrößert.

In einer weiteren vorteilhaften Ausgestaltung sind an den Übergängen zwischen den jeweiligen Abschnitten der Kontaktschenkel sowie an den Übergängen zwischen Kontaktschenkeln und Steg jeweils Rundungen ausgebildet. Dies führt zu einem verbesserten Kraftfluss während des Einsetzvorgangs und vermeidet das Bilden von Rissen, welche leicht an scharfen Kanten bzw. Übergängen entstehen können. Dabei ist es besonders vorteilhaft wenn der minimale Krümmungsradius der Rundungen 0,01 mm beträgt. Ebenso trägt es zu einem vorteilhaften Kraftfluss bei, wenn der Steg an den beiden Öffnungen nach innen gewölbt ist.

Eine erfindungsgemäße Steckverbindung umfasst:
ein erfindungsgemäßes stiftförmiges Kontaktelement, und
eine in einer Leiterplatte vorgesehenen Pinaufnahme zur Aufnahme des Kontaktelements, die als metallisiertes Durchgangsloch durch die Leiterplatte ausgebildet ist,
wobei im aufgenommenen Zustand des stiftförmigen Kontaktelements das durch den Steg gebildete Federelement gespannt ist.

Die Leiterplatte kann aus einem isolierenden Material gebildet sein. Innerhalb des isolierenden Materials können metallische Leiterbahnen vorgesehen sein, welche in Kontakt mit der Metallisierung des Durchgangslochs stehen. Durch die Verwendung des erfindungsgemäßen Kontaktstifts wird dabei gewährleistet, dass der Kontakt zwischen den Leiterbahnen und der Aufnahmehülse nicht durch den oben beschriebenen Jet-Effekt beeinträchtigt wird.

### ZEICHNUNGEN

Die Erfindung wird nachfolgend anhand der in den schematischen Figuren der Zeichnungen angegebenen Ausführungsbeispiele näher erläutert. Es zeigt dabei:
Fig. 1 eine schematische Darstellung einer herkömmlichen Steckverbindung mit einer Leiterplatte und einem stiftförmigen Kontaktelement;
Fig. 2A eine Draufsicht auf ein erfindungsgemäßes stiftförmiges Kontaktelement;
Fig. 2B einen Querschnitt durch das stiftförmige Kontaktelement in Fig. 2A entlang der Linie A - A;
Fig. 3A eine vergrößerte Darstellung eines Ausschnitts Y der Draufsicht in Fig. 2A;
Fig. 3B eine vergrößerte Darstellung eines Ausschnitts X des Querschnitts in Fig. 2B;
Fig. 4A einen schematischen Querschnitt durch das erfindungsgemäße stiftförmige Kontaktelement im nicht eingepressten Zustand;
Fig. 4B einen schematischen Querschnitt durch das erfindungsgemäße stiftförmige Kontaktelement im eingepressten Zustand; und
Fig. 5 eine schematische Darstellung einer erfindungsgemäßen Steckverbindung mit einer Leiterplatte und einem stiftförmigen Kontaktelement.

In allen Figuren der Zeichnungen sind gleiche bzw. funktionsgleiche Elemente - sofern nichts Anderes angegeben ist - mit gleichen Bezugszeichen versehen worden.

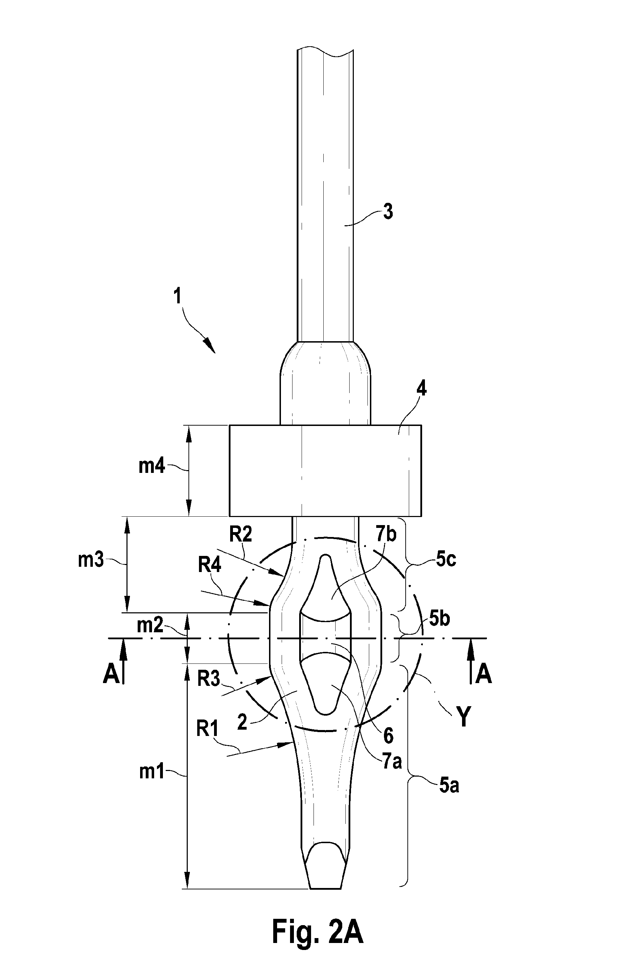

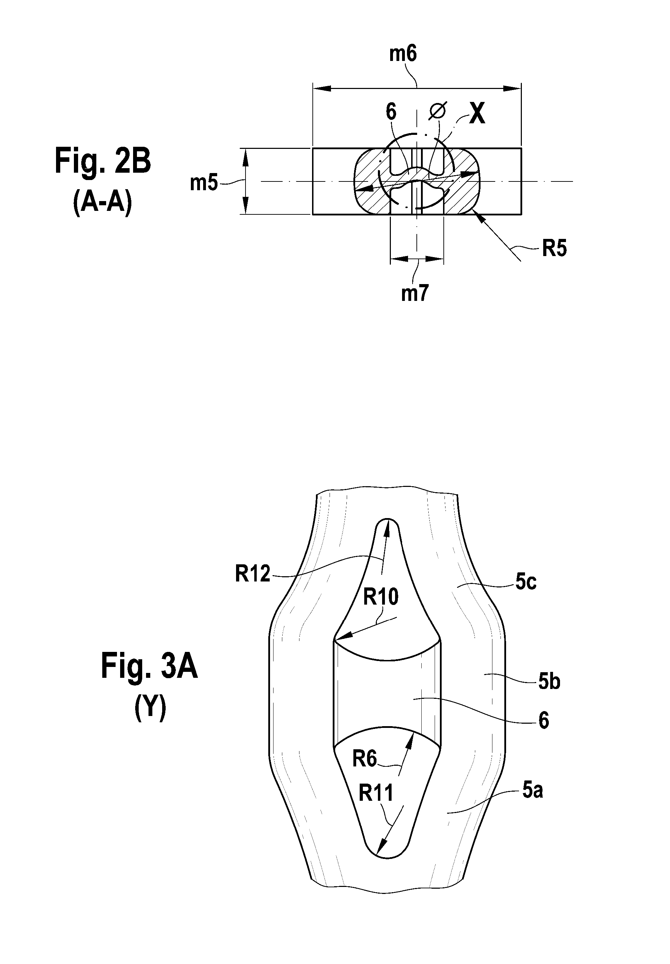

Fig. 2A zeigt eine Draufsicht auf ein erfindungsgemäßes stiftförmiges Kontaktelement 1 und Fig. 2B einen Querschnitt durch das stiftförmige Kontaktelement 1 in Fig. 2A entlang der Linie A-A.

Das Kontaktelement 1 umfasst auf der einen Seite einen zylindrischen Kontaktdraht 3 und auf der anderen Seite eine Einpresszone 2, welche durch eine Einpressschulter 4 mit dem Kontaktdraht 3 verbunden ist. Die Höhe der Einpressschulter 4 beträgt beispielsweise m4 = 1 mm, ihre Länge m6 = 2 mm und ihre Breite m5 = 0,63 mm. Das Kontaktelement 1 kann beispielsweise aus CuSiNi oder dergleichen bestehen und durch Stanzen und Prägen hergestellt werden.

Die Einpresszone 2 umfasst zwei Schenkel 5, die jeweils aus drei Abschnitten 5a, 5b, 5c bestehen, nämlich einem ersten Schenkelabschnitt 5a, welcher am freien Ende des Kontaktelements 1 angeordnet ist, einem zweiten Schenkelabschnitt 5b, welcher sich an den ersten Schenkelabschnitt 5a anschließt, sowie einem dritten Schenkelabschnitt 5c, welcher sich an den zweiten Schenkelabschnitt 5b anschließt und mit der Einpressschulter 4 verbunden ist.

Die beiden ersten Schenkelabschnitte 5a sind, ebenso wie die beiden dritten Schenkelabschnitte 5c an ihren den zweiten Abschnitten 5b abgewandeten Seiten miteinander verschmolzen und somit einstückig miteinander verbunden. Die beiden ersten Schenkelabschnitte 5a bilden somit, ebenso wie die beiden dritten Schenkelabschnitte 5c, zusammen im Wesentlichen die Form eines gerundeten ,Y'. Die ersten Abschnitte 5a sind am freien Ende der Einpresszone 2 im Wesentlichen parallel zueinander angeordnet und sind zu den zweiten Abschnitten 5b hin auseinandergespreizt. Dies ermöglicht ein einfaches Einführen in eine Pinaufnahme. Insbesondere wird somit gewährleistet, dass die Kraft, mit welcher die Schenkel 5 beim Einführen in die Pinaufnahme zusammengedrückt werden und welche von den Schenkeln 5 auf die Aufnahmehülse wirkt zunächst sehr gering ist und danach nur graduell zunimmt. Bei der in Fig. 1 dargestellten Nadelöhrform dagegen sitzt das Nadelöhr zunächst auf der Oberkante der Aufnahmehülse auf, so dass beim Einpressen beim anfänglichen Kontakt eine größere Kraft auf die Aufnahmehülse übertragen wird. Um das Einführen in eine Pinaufnahme noch mehr zu vereinfachen, kann das freie Ende der Einpresszone 2 durch ein Abschrägen der Endseiten der Kontaktschenkel 5 "angespitzt" sein. Die ersten Abschnitte 5a weisen einen über ihre Längsausdehnung im Wesentlichen konstanten Krümmungsradius von beispielsweise R1 = 4,05 mm auf. Die Länge der ersten Abschnitte 5a in beträgt in ihrer Längsausdehnung beispielsweise m1 = etwa 2,4 mm.

Die zweiten Schenkelabschnitte 5b sind in ihrer Längsausdehnung im Wesentlichen gerade ausgebildet. Somit wird eine größere Kontaktfläche zwischen Einpresszone und Aufnahmehülse 12 gewährleistet. Die Längsausdehnung der zweiten Abschnitte beträgt beispielsweise m2 = 0,5 mm. Der Abstand zwischen den zwei Schenkeln 5 beträgt im Bereich der zweiten Abschnitte 5b beispielsweise m7 = 0,5 mm.

Die dritten Abschnitte 5c sind von der Kontaktschulter 4 zu den zweiten Abschnitten 5b hin ebenfalls nach außen gespreizt. Auch die dritten Abschnitte 5c weisen einen über ihre Längsausdehnung im Wesentlichen konstanten Krümmungsradius von beispielsweise R2 = 1,35 mm auf. Die Länge der dritten Abschnitte 5c beträgt in ihrer Längsausdehnung beispielsweise m3 = etwa 1,1 mm.

Zwischen den ersten und zweiten Abschnitten 5a, 5b sowie zwischen den zweiten und dritten Abschnitten 5b und 5c sind jeweils Rundungen vorgesehen, um einen gerundeten Übergang ohne Kanten zwischen diesen Abschnitten zu gewährleisten. Dabei beträgt der Krümmungsradius des Übergangs zwischen den ersten und zweiten Abschnitten 5a, 5b beispielsweise R3 = 0,45 mm und der Krümmungsradius des Übergangs zwischen den zweiten und dritten Abschnitten 5b und 5c beispielsweise ebenfalls R4 = 0,45 mm.

Die Schenkel sind nach außen hin rund mit einem Krümmungsradius von beispielsweise R5 = 0,2 mm, was vorzugsweise dem Innenradius der Aufnahmehülse 12 entspricht, um somit gute Kontakteigenschaften zu gewährleisten. Ferner weist die Einpresszone im mittleren Abschnitt 5b beispielsweise einen Durchmesser von 0 = 1,17 mm auf.

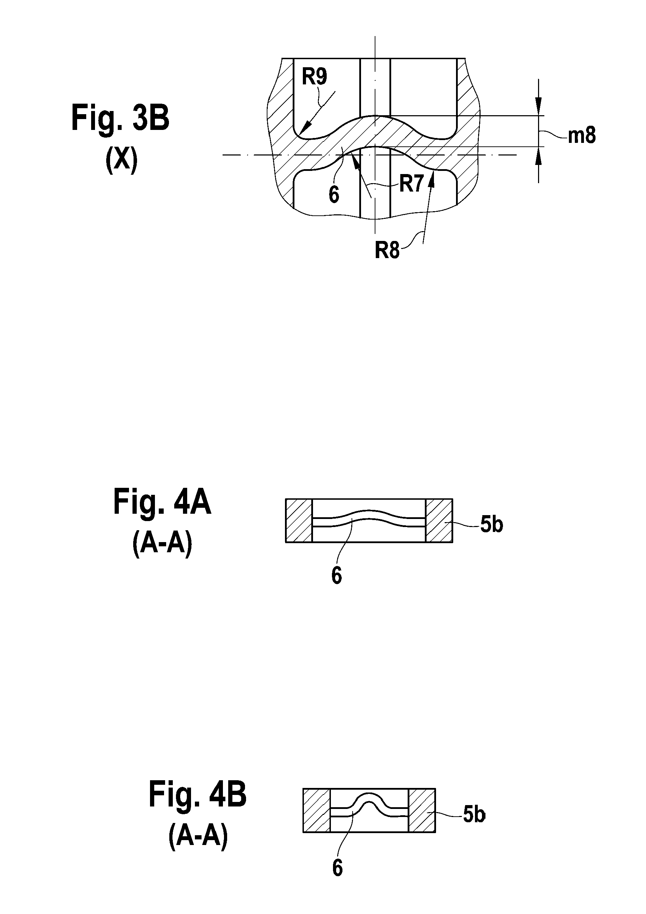

Zwischen den zweiten Schenkelabschnitten 5b ist ein Steg 6 vorgesehen, welcher als Federelement dient. Dies ist schematisch in Fig. 4 gezeigt, wobei Fig. 4A einen schematischen Querschnitt durch das Kontaktelement 1 im nicht eingepressten Zustand zeigt und Fig. 4B einen schematischen Querschnitt durch das Kontaktelement 1 im eingepressten Zustand zeigt. Im eingeknickten Zustand ist der Steg 6 zu einer Seite hin ausgeknickt. In diesem Zustand wirkt der Steg 6 als Blattfeder, die die beiden Schenkel 5 auseinander und somit gegen die Innenwandung der Pinaufnahme drückt. Auf diese Weise werden gute Haltekräfte über die Lebensdauer des Produktes erzielt. Ferner ist die Anordnung aufgrund der Federwirkung auch sehr stabil gegenüber Temperaturschwankungen (zyklenfest) und ermöglicht somit den Einsatz über einen großen Temperaturbereich.

Der Steg 6 definiert gemeinsam mit den Schenkelabschnitten 5a eine erste Öffnung 7a und gemeinsam mit den Schenkelabschnitten 5c eine zweite Öffnung 7b. Der Steg 6 hat eine Dicke von beispielsweise m8 = 0,1 mm. In der Draufsicht ist der Steg 6 wie in den Fign. 2A und 3A dargestellt taillenförmig. Auf der der ersten Öffnung 7a zugewandten Seite sowie der zweiten Öffnung 7b zugewandten Seite weist der Steg 6 einen konstanten Krümmungsradius von R6 = 0,4 mm auf. Diese taillenförmige Ausbildung des Stegs 6 hat den Vorteil eines optimierten Kraftflusses während des Einpressvorgangs.

Der Steg 6 ist in seinem mittleren Bereich zu einer Seite hin mit einer Wölbung versehen. Im Bereich dieser Wölbung ist der Steg 6 beispielsweise mit einem Krümmungsradius von R7 = 0,1 mm gekrümmt. In den beiden rechts und links an diesen mittleren Bereich anschließenden Bereichen ist der Steg beispielsweise mit einem Krümmungsradius von R8 = 0,3 mm in entgegen gesetzter Richtung gekrümmt. Durch diese Wölbung wird eine Ausknickrichtung des Stegs 6 festgelegt. Wird das Kontaktelement 1 in eine Pinaufnahme geschoben, dann werden die beiden Schenkel 5 zusammengedrückt. Der Steg 6 knickt dabei in die Richtung der Wölbung im mittleren Bereich ein.

Durch diese konstruktive Festlegung der Verformungsrichtung der Feder wird erreicht, dass die Einpresskraft, welche zum Einpressen des Kontaktelements 1 notwendig ist, geringer ist, da der Steg 6 (die Feder) unmittelbar beim Zusammendrücken der Schenkel 5 ausknickt. Dies vereinfacht den Einsetzprozess. Ferner können genau definierte Einpresskräfte erreicht werden. Mit anderen Worten, die Schwankungsbreite der Einpresskräfte beim Einpressvorgang ist geringer. Dies ist insbesondere bei der Verwendung von Placement-Tools für die Platzierung von Bauteilen mit Kontaktstiften 1 von Vorteil, da somit der Platzierungsprozess mit geringeren Toleranzen versehen werden kann.

Ist dagegen keine vordefinierte Einpressrichtung der Feder (also hier des Stegs) vorgesehen, dann unterliegt die Richtung, in welcher die Feder ausknickt, letztendlich dem Zufall. Ferner hängt dann die Einpresskraft, bei welcher die Feder ausknickt, stark von Faktoren wie der Verarbeitungsgenauigkeit ab.

Es ist insbesondere von Vorteil, wenn der mittlere Stegbereich aufgrund der Wölbung so weit versetzt ist, dass sowohl eine Unterseite als auch eine Oberseite des Stegs im mittleren Stegbereich auf der selben Seite einer die beiden Kontaktschenkel verbindenden Linie durch die Mitte des Stegs liegen. Dies ist in der Fig. 3B dargestellt, welche zeigt, dass sowohl Unterseite als auch Oberseite des Stegs 6 auf derselben Seite der als strichpunkierte Linie dargestellten Mittellinie durch den Steg 6 liegen. Dies gewährleistet, dass beim Einpressen kein Zustand vorliegen kann, in welchen die von den Schenkeln 5 durch den Steg 6 wirkenden Kräfte sich gegenseitig aufheben. Folglich ist gewährleistet, dass der Steg 6 beim Einpressen ohne weiteres ausknickt.

Weiterhin sind in der dargestellten Ausführungsform nicht nur sämtliche Übergänge zwischen den Kontaktschenkeln 5 sondern auch sämtliche Übergänge zwischen Kontaktschenkeln 5 und Steg 6 gerundet. So ist der Übergang zwischen dem Steg 6 und dem mittleren Abschnitt 5b der Kontaktschenkel in seitlicher Richtung mit einer Rundung von beispielsweise R9 = 0,05 mm versehen. Ferner ist der Übergang zwischen dem Steg 6 und dem mittleren Abschnitt 5b der Kontaktschenkel in der Draufsicht mit einer Rundung von beispielsweise R10 = 0,01 mm versehen. Auch die Bereiche in denen die Abschnitte 5a und 5c der beiden Schenkel 5 jeweils zusammen laufen sind mit Rundungen von beispielsweise R11 = 0,1 mm bzw. R12 = 0,05 mm versehen. Es sind somit in der gesamten Einpresszone 2 keine scharfen Kanten oder Übergänge vorhanden. Dies ermöglicht einen günstigen Kraftfluss während des Einpressvorgangs und stellt sicher, dass aufgrund der Kerbwirkung keine Risse oder dergl. entstehen.

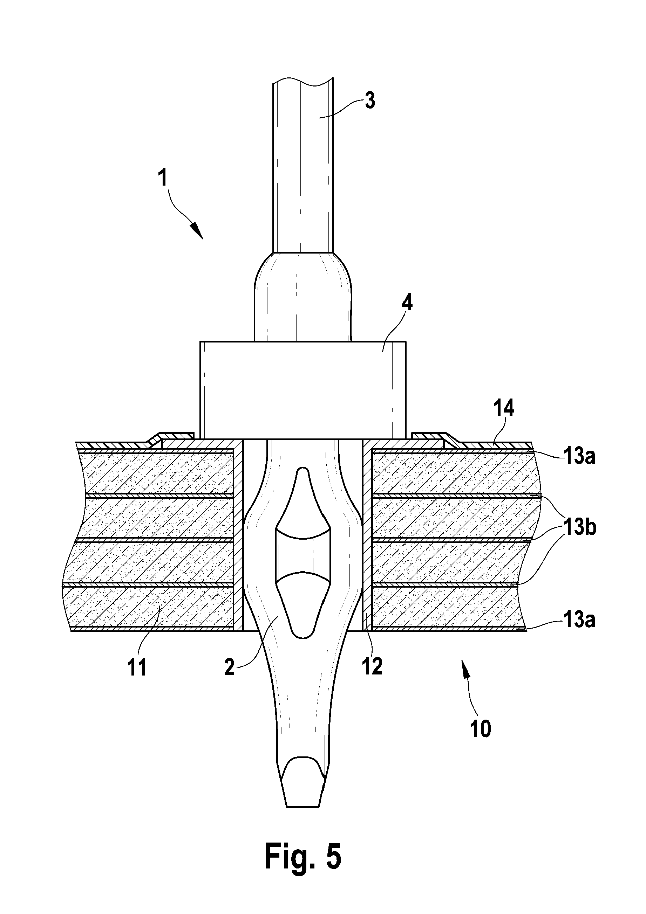

Fig. 5 zeigt schematisch eine erfindungsgemäße Steckverbindung mit einer Leiterplatte 10 und einem Kontaktstift 1, der wie oben beschrieben ausgebildet ist, und in die Leiterplatte 10 eingepresst ist.

Die Leiterplatte 10 umfasste eine plattenförmige Glasfasermatrix 11, in welcher ein Durchgangsloch ausgebildet ist. In dieses Durchgangsloch ist eine hohlzylindrische Aufnahmehülse 12 aus Kupfer eingesetzt, welche das Durchgangsloch von innen auskleidet. Die Aufnahmehülse 12 ist mit metallischen Leiterbahnen 13a und 13b in Kontakt, welche ebenfalls aus Kupfer bestehen. Die Leiterbahnen 13a und 13b umfassen Außenbahnen 13a, welche an der Oberfläche der Leiterplatte 10 vorgesehen sind, sowie Innenbahnen 13b, welche parallel zur Oberfläche der Leiterplatte 10 im Innern der Leiterplatte 10 verlaufen. Die in der Leiterplatte 10 vorgesehene Aufnahmehülse 12 bildet eine Pinaufnahme für den Kontaktstift 1. An der Oberfläche der Leiterplatte 10 ist eine die obere Leiterbahn bedeckende Lötstoppmaske 14 vorgesehen.

Durch das Einpressen des Kontaktstifts 1 in die Pinaufnahme wird ein elektrischer Kontakt zwischen dem Kontaktstift 1 und den Leiterbahnen 13a und 13b hergestellt. Wie in der Fig. 5 dargestellt ist dabei die Kontaktfläche zwischen dem Kontaktstift 1 und der Aufnahmehülse 12 aufgrund der geraden mittleren Abschnitte 5b vergleichsweise groß. Weiterhin gewährleistet die oben beschriebene Form des Kontaktstifts 1, dass die benötigte Einpresskraft relativ gering ist und zudem genau bestimmbar.

Obwohl die obige Ausführungsform vorstehend anhand von bevorzugten Ausführungsbeispielen beschrieben wurde, ist sie darauf nicht beschränkt, sondern auf vielfältige Art und Weise modifizierbar. So sind sämtliche der oben genannten Bemassungen als lediglich illustrativ und nicht die Erfindung einschränkend zu betrachten.

## Patentansprüche

1. Stiftförmiges Kontaktelement (1) zur kontaktgebenden Befestigung in einer Pinaufnahme einer Leiterplatte (10), wobei das Kontaktelement (1) eine im Wesentlichen nadelöhrförmigen Einpresszone (2) aufweist, mit:
zwei federelastisch aufeinander zu bewegbaren Kontaktschenkeln (5), deren Enden auf beiden Seiten miteinander verbunden sind, und
einem als Federelement dienenden Steg (6), welcher zwischen den Kontaktschenkeln (5) angeordnet ist, wobei der Steg (6) derart verformt ist, dass er eine vordefinierte Ausknickrichtung aufweist.

2. Stiftförmiges Kontaktelement (1) nach Anspruch 1,
wobei die zwei Kontaktschenkel (5) jeweils einen ersten, einen zweiten und einen dritten Abschnitt (5a; 5b; 5c) aufweisen, wobei der zweite Abschnitt (5b) zwischen dem ersten Abschnitt (5a) und dem dritten Abschnitt (5c) angeordnet ist und die ersten Abschnitte (5a) und die dritten Abschnitte (5c) der Kontaktschenkel (5) an ihren dem zweiten Abschnitt (5b) abgewandten Enden jeweils miteinander verbunden sind, und
wobei der Steg (6) zwischen den zweiten Abschnitten (5b) der Kontaktschenkel (5) angeordnet ist, so dass der Steg (6) zusammen mit den ersten Abschnitten (5a) und den dritten Abschnitten (5c) jeweils eine Öffnung (7a; 7b) definiert.

3. Stiftförmiges Kontaktelement (1) nach Anspruch 1 oder 2,
wobei der Steg (6) einen mittleren Bereich aufweist, welcher gegenüber den den Kontaktschenkeln (5) zugewandten Enden des Stegs (6) zu einer Seite hin gewölbt ist, so dass der Steg (6) beim Einpressen des Kontaktelements (1) in die Pinaufnahme zu dieser Seite hin ausknickt.

4. Stiftförmiges Kontaktelement (1) nach Anspruch 3,
wobei der durch die Wölbung vorgegebene Versatz des mittleren Stegbereiches so groß ist, dass sowohl eine Unterseite als auch eine Oberseite des Stegs (6) im mittleren Stegbereich auf derselben Seite einer die beiden Kontaktschenkel (5) verbindenden Linie durch die Mitte des Stegs (6) liegen.

5. Stiftförmiges Kontaktelement (1) nach einem der vorhergehenden Ansprüche,
wobei die ersten Abschnitte (5a) der Kontaktschenkel (5) am freien Ende des Kontaktelements (1) im Wesentlichen parallel zueinander angeordnet sind, und
die ersten Abschnitte (5a) vom freien Ende zu den zweiten Abschnitten (5b) hin nach außen gespreizt sind.

6. Stiftförmiges Kontaktelement (1) nach einem der vorhergehenden Ansprüche,
wobei die zweiten Abschnitte (5b) der Kontaktschenkel (5) im Wesentlichen gerade ausgebildet sind.

7. Stiftförmiges Kontaktelement (1) nach einem der vorhergehenden Ansprüche,
wobei an den Übergängen zwischen den jeweiligen Abschnitten der Kontaktschenkel (5) sowie an den Übergängen zwischen Kontaktschenkeln (5) und Steg (6) Rundungen ausgebildet sind.

8. Stiftförmiges Kontaktelement (1) nach einem der vorhergehenden Ansprüche,
wobei der minimale Krümmungsradius der Rundungen 0,01 mm beträgt.

9. Stiftförmiges Kontaktelement (1) nach einem der vorhergehenden Ansprüche,
wobei der Steg (6) an den beiden Öffnungen (7a; 7b) nach innen gewölbt ist.

10. Steckverbindung mit:
einem stiftförmigen Kontaktelement (1) nach einem der vorhergehenden Ansprüche, und
einer in einer Leiterplatte (10) vorgesehenen Pinaufnahme zur Aufnahme des Kontaktelements (1), die als metallisiertes Durchgangsloch durch die Leiterplatte (10) ausgebildet ist,
wobei im aufgenommenen Zustand des stiftförmigen Kontaktelements (1) das durch den Steg (6) gebildete Federelement gespannt ist.

11. Steckverbindung nach Anspruch 10,
wobei die Leiterplatte (10) aus einem isolierenden Material gebildet ist, und wobei innerhalb des isolierenden Materials metallische Leiterbahnen (13) vorgesehen sind, welche in Kontakt mit der Metallisierung (12) des Durchgangslochs stehen.
